# FASCICULE DE BREVET EUROPEEN

(11) **EP 3 829 063 B1**
(45) Date de publication et mention de la délivrance du brevet: **11.10.2023**
(21) Numéro de dépôt: 20210077.2
(22) Date de dépôt: 26.11.2020
(51) Int. Cl.: H03K 17/10, H02M 1/08, H03K 17/06, H03K 17/30, H03K 17/13

(54) **COMMANDE D'INTERRUPTEUR BIDIRECTIONNEL**
BIDIREKTIONALE SCHALTERSTEUERUNG
BI-DIRECTIONAL SWITCH CONTROL

(30) Priorité: 28.11.2019 FR 1913396
(43) Date de publication de la demande: 02.06.2021
(73) Titulaire: Commissariat à l'Energie Atomique et aux Energies Alternatives, 75015 Paris (FR)
(72) Inventeur: BERGOGNE, Dominique, 38054 GRENOBLE CEDEX 9 (FR)
(74) Mandataire: Cabinet Beaumont

(56) Documents cités:
- DE-A1- 4 321 971
- DE-A1-102015 011 396
- US-A- 5 883 495
- US-A1- 2013 257 406
- US-A1- 2016 079 233

## Description

### Domaine technique

La présente description concerne de façon générale les dispositifs électroniques, en particulier les convertisseurs à découpage.

### Technique antérieure

Les convertisseurs à découpage utilisent un ou des interrupteurs mis alternativement aux états passant et bloqué à une fréquence de découpage. On utilise des convertisseurs à découpage pour fournir une tension et/ou un courant à partir d'une alimentation ayant des valeurs de tension/courant différentes des valeurs des tension/courant à fournir. Par exemple, un convertisseur à découpage de type alternatif-continu AC-DC (en anglais "Alternating current-Direct current") permet d'obtenir une tension continue à partir d'une tension alternative telle que celle d'un réseau électrique ou d'un alternateur.

Le document DE 10 2015 011396 décrit un dispositif et un procédé pour connecter et déconnecter électriquement deux potentiels électriques ainsi que l'utilisation d'un tel dispositif.

### Résumé de l'invention

Il existe un besoin d'améliorer le fonctionnement des convertisseurs à découpage connus, en particulier des convertisseurs connus recevant et/ou fournissant une tension alternative.

Il existe un besoin d'augmenter le rendement des convertisseurs à découpage connus, en particulier des convertisseurs connus recevant et/ou fournissant une tension alternative.

Il existe un besoin de simplifier la mise en oeuvre des interrupteurs des convertisseurs à découpage connus, en particulier des convertisseurs connus recevant et/ou fournissant une tension alternative.

Un mode de réalisation pallie tout ou partie des inconvénients des circuits connus de commande d'interrupteurs de convertisseur à découpage.

Un mode de réalisation pallie tout ou partie des inconvénients des convertisseurs à découpage connus.

Un mode de réalisation permet d'améliorer et de fiabiliser le fonctionnement d'un interrupteur de convertisseur à découpage.

Un mode de réalisation permet une mise en oeuvre particulièrement simple d'interrupteurs de convertisseur à découpage.

Un mode de réalisation prévoit un procédé de commande d'un interrupteur bidirectionnel, tel que défini dans la revendication indépendante 1.

Un mode de réalisation prévoit un circuit tel que défini dans la revendication indépendante 9.

Un mode de réalisation prévoit un dispositif tel que défini dans la revendication dépendante 15.

Un mode de réalisation prévoit un dispositif monolithique tel que défini dans la revendication dépendante 16.

Un mode de réalisation prévoit un convertisseur à découpage tel que défini dans la revendication dépendante 17.

D'autres caractéristiques préférées sont définies dans les revendications dépendantes.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de manière partielle et schématique, un exemple de cellule de commutation de convertisseur à découpage alimenté par une tension alternative, d'un type auquel s'appliquent les modes de réalisation décrits ;
la figure 2 représente une vue en coupe schématique d'un interrupteur bidirectionnel d'un type auquel s'appliquent les modes de réalisation décrits, pouvant être utilisé dans une cellule de commutation telle que celle de la figure 1 ;
la figure 3 représente, de manière schématique, un mode de réalisation d'un circuit de commande d'interrupteur bidirectionnel, relié à un interrupteur bidirectionnel comprenant deux transistors ;
la figure 4 représente, de manière schématique, un mode de réalisation d'une partie du circuit de commande de la figure 3 ;
la figure 5 représente, de manière schématique et sous forme de chronogrammes, un mode de réalisation d'un procédé mis en oeuvre par le circuit de commande de la figure 3 ;
la figure 6 représente, de manière schématique, un autre mode de réalisation d'un circuit de commande d'interrupteur bidirectionnel relié à un interrupteur bidirectionnel comprenant deux interrupteurs ;
la figure 7 représente, de manière très schématique, encore un autre mode de réalisation d'un circuit de commande d'interrupteur bidirectionnel, relié à un interrupteur bidirectionnel comprenant deux interrupteurs ;
la figure 8 représente, de manière schématique, un exemple d'un mode de réalisation d'un module du circuit de la figure 7 ;
la figure 9 représente, de manière schématique et sous forme de chronogrammes, un exemple d'un mode de réalisation d'un procédé mis en oeuvre par le module de la figure 8 ;
la figure 10 représente, de manière partielle et schématique, un exemple d'un autre mode de réalisation d'un module du circuit de la figure 7 ; et
la figure 11 représente, de manière partielle et schématique, un exemple d'encore un autre mode de réalisation d'un module du circuit de la figure 7.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, un circuit d'attaque (ou de commande, par exemple de commande de grille de transistor) (en anglais "driver"), prévu pour appliquer une commande à un interrupteur bidirectionnel (c'est-à-dire appliquer une tension à une électrode de contrôle ou borne de commande telle qu'une grille de transistors formant l'interrupteur), n'est pas décrit en détail, les modes de réalisation décrits étant compatibles avec les circuits d'attaque usuels.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Sauf précision contraire, les adjectifs numéraux ordinaux, tels que "premier", "deuxième", etc., sont utilisés seulement pour distinguer des éléments entre eux. En particulier, ces adjectifs ne limitent pas les dispositifs et procédés décrits à un ordre particulier de ces éléments.

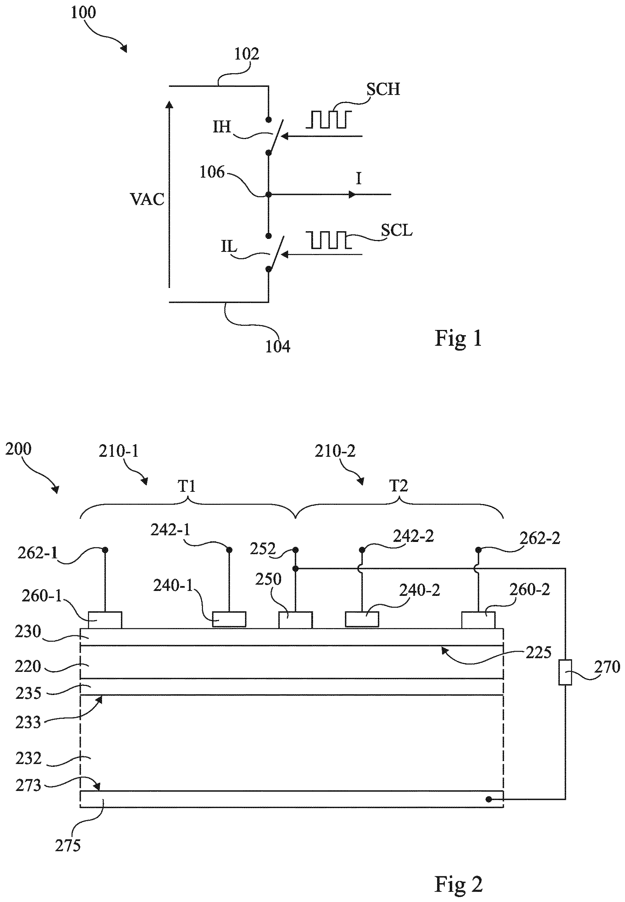

La figure 1 représente, de manière partielle et schématique, un exemple de cellule de commutation 100 d'un convertisseur à découpage, d'un type auquel s'appliquent les modes de réalisation décrits.

Une cellule de commutation est définie par l'association de deux interrupteurs IH et IL électriquement en série entre des noeuds 102 et 104. Des signaux SCH et SCL de commande des interrupteurs respectifs IH et IL sont de sorte que, lorsque l'un des interrupteurs IH et IL est passant, l'autre des interrupteurs est bloqué. Ainsi, les interrupteurs IH et IL ne sont pas passants simultanément. Les interrupteurs IH et IL peuvent aussi être bloqués simultanément.

Le convertisseur dans lequel se trouve la cellule de commutation 100 reçoit ou fournit une tension alternative. De préférence, le convertisseur est de type AC-DC, et la tension alternative est la tension, reçue par le convertisseur, à partir de laquelle le convertisseur produit une tension continue par l'intermédiaire du découpage de la tension alternative. Le fonctionnement inverse est aussi possible, l'entrée étant du côté DC et la sortie du côté AC. Dans l'exemple représenté, la cellule de commutation 100 reçoit la tension alternative VAC, et fournit, sur un noeud 106 de connexion en série des interrupteurs IH et IL, un courant I. Le courant I est reçu par des éléments non représentés du convertisseur, et utilisé par ces éléments pour produire la tension continue. Le courant I est par exemple le courant dans une inductance, non représentée, interne au convertisseur. La structure du convertisseur, ainsi que les signaux SCH et SCL des interrupteurs, n'est pas détaillée ici, les modes de réalisation décrits étant compatibles avec les convertisseurs à découpage usuels et les commandes usuelles d'interrupteurs de convertisseurs à découpage.

Dans une application typique, la tension alternative VAC provient d'un réseau de distribution électrique, et a par exemple une tension efficace de l'ordre d'environ 110 V ou d'environ 230 V, et par exemple une fréquence égale à 50 Hz ou 60 Hz. La tension alternative VAC est ainsi une tension élevée, c'est-à-dire de valeur crête supérieure à 100 V, par exemple égale à environ 150 V, de préférence supérieure à 300 V, par exemple égale à environ 350 V. La tension continue est typiquement utilisée pour charger une batterie, par exemple une batterie d'un ordinateur portable ou d'un dispositif mobile de communication à distance tel qu'un téléphone mobile.

En fonctionnement, la tension alternative VAC prend successivement des valeurs positives (potentiel du noeud 102 supérieur à celui du noeud 104) et négatives (potentiel du noeud 102 inférieur à celui du noeud 104). Pour assurer ce fonctionnement, les interrupteurs IH et IL sont bidirectionnels en tension. Un interrupteur bidirectionnel en tension est défini par un interrupteur apte, à un état bloqué, à empêcher le passage d'un courant pour les deux sens de la tension aux bornes de l'interrupteur bidirectionnel. L'interrupteur bidirectionnel est configuré pour, à un état passant, permettre le passage d'un courant circulant dans l'interrupteur bidirectionnel d'une borne à l'autre de l'interrupteur bidirectionnel.

En outre, le courant I fourni peut être, dans certaines applications, alternatif, par exemple, le courant I est alternatif à la fréquence de découpage et est fourni à, ou provient de, un transformateur non représenté. Pour cela, les interrupteurs sont en outre, de préférence, bidirectionnels en courant. Un interrupteur bidirectionnel en courant est défini par un interrupteur apte, à son état passant, à permettre le passage d'un courant dans les deux sens entre ses bornes. L'interrupteur bidirectionnel en courant est configuré pour, à l'état passant, connecter électriquement ses bornes entre elles.

Les signaux de commande SCH et SCL sont typiquement en créneaux. Par signal en créneaux, on entend un signal comprenant une succession de cycles, chaque cycle comprenant une partie à un niveau bas du signal et une partie à un niveau haut du signal. Les cycles des signaux SCH et SCL sont répétés à une fréquence de découpage. Ainsi, à la fréquence de découpage, on rend alternativement l'interrupteur IH passant et l'interrupteur IL bloqué, puis l'interrupteur IL passant et l'interrupteur IH bloqué. La fréquence de découpage est plus élevée que celle de la tension alternative VAC, de préférence supérieure à 1 MHz. Les procédés de génération des signaux de commande des divers interrupteurs du convertisseur ne sont pas décrits en détail, les modes de réalisation décrits étant compatibles avec les procédés usuels de génération de signaux de commande d'interrupteurs d'un convertisseur à découpage.

Les modes de réalisation décrits sont applicables à tout convertisseur à découpage, en particulier à tout convertisseur destiné à recevoir et/ou fournir une tension ayant des signes successifs différents, c'est-à-dire une tension alternative. La tension alternative peut être monophasée ou multiphasée. En particulier, les modes de réalisation décrits sont applicables à tout convertisseur comprenant, entre deux noeuds d'application de la tension alternative ou d'une phase de la tension alternative, une ou plusieurs branches en parallèle chacune constituée d'une cellule de commutation comprenant au moins deux interrupteurs en série. L'un au moins de ces deux interrupteurs est bidirectionnel. Par bidirectionnel, on entend bidirectionnel en tension et, de préférence, en courant. De préférence, dans la ou chaque branche, les deux interrupteurs sont bidirectionnels.

La figure 2 représente, par une vue en coupe schématique, un exemple d'interrupteur bidirectionnel 200 d'un type auquel s'appliquent les modes de réalisation décrits. L'interrupteur bidirectionnel 200 peut constituer tout interrupteur bidirectionnel d'un convertisseur à découpage tel que décrit ci-dessus. Par exemple, les interrupteurs IH et IL de la cellule de commutation 100 de la figure 1 sont chacun identique ou similaire à l'interrupteur bidirectionnel 200.

L'interrupteur bidirectionnel 200 comprend deux interrupteurs 210-1 et 210-2 électriquement en série. De préférence, les interrupteurs 210-1 et 210-2 comprennent des transistors à effet de champ respectifs T1 et T2. Les transistors T1 et T2 peuvent alors être de tout type à effet de champ. Cependant, préférentiellement, les transistors T1 et T2 sont du type représenté, dit transistor à haute mobilité électronique, HEMT (de l'anglais "High Electron-Mobility Transistor"). De tels transistors comprennent deux couches semiconductrices 220 et 230 ayant des bandes interdites différentes et en contact l'une avec l'autre, les couches semiconductrices 220 et 230 définissant alors entre elles une interface 225 le long de laquelle les électrons sont mobiles. Un tel transistor permet de bloquer des tensions plus élevées et permet des commutations plus rapides que d'autres types de transistors à effet de champ. Plus préférentiellement, les semiconducteurs des couches 220 et 230 sont respectivement du nitrure de Gallium GaN et du nitrure d'aluminium-gallium AlGaN. On parle alors de transistor de type HEMT à GaN.

Les couches 220 et 230 reposent typiquement sur un support 232. Plus précisément, les couches 220 et 230 reposent sur une face 233 du substrat 232 (face supérieure en figure 2, dite aussi face avant). Le support 232 est par exemple une portion de tranche (en anglais "wafer") semiconductrice, telle qu'une tranche de silicium. Le support 232 peut être recouvert de couches tampon 235 situées entre le support 232 et la couche 220, destinées à faciliter la formation de la couche 220 sur le support 232. Divers éléments, tels que des régions isolantes, ainsi que les matériaux autres que ceux décrits ci-dessus, et des dimensions telles que les épaisseurs des couches, ne sont pas détaillés ici, les modes de réalisation décrits étant compatibles avec les transistors HEMT à GaN usuels.

Bien que, dans l'exemple représenté, chaque interrupteur 210-1, 210-2 comprenne seulement un transistor, respectivement T1, T2, l'interrupteur 210-1 peut comprendre plusieurs transistors T1 électriquement en parallèle les uns des autres, et l'interrupteur 210-2 peut comprendre plusieurs transistors T2 électriquement en parallèle les uns des autres.

Les transistors T1 et T2 comprennent chacun une grille, respectivement 240-1, 240-2, et une région de drain, respectivement 260-1, 260-2. Dans l'exemple représenté, les grilles et les régions de drain sont situées sur la couche 230.

Les transistors T1 et T2 comprennent chacun une borne, respectivement 242-1, 242-2, reliée, de préférence connectée, aux grilles respectives 240-1 et 240-2. Les bornes 242-1 et 242-2 constituent des bornes de commande des interrupteurs respectifs 210-1 et 210-2. Les transistors T1 et T2 comprennent chacun une borne, respectivement 262-1, 262-2 reliée, de préférence connectée, à la région de drain, respectivement 260-1, 260-2. Les bornes 262-1, 262-2 forment les bornes de conduction de l'interrupteur bidirectionnel 200.

De préférence, l'interrupteur bidirectionnel 200 comprend une borne de source 252 commune aux transistors T1 et T2, connectée à une région de source 250 commune aux transistors T1 et T2. Dans l'exemple représenté, la région de source commune 250 est située sur la couche 230. Dans chaque transistor T1, T2, la grille, respectivement 240-1, 240-2, est située entre la région de drain, respectivement 260-1, 260-2, et la région de source commune 250. Dans une variante, la borne commune de source 252 est reliée, par exemple connectée, à des régions de source distinctes dans les transistors T1 et T2. Dans une autre variante, les transistors T1 et T2 ont des bornes de source distinctes.

De préférence, la borne commune de source 250 est reliée électriquement, ou connectée électriquement, au substrat 232. Pour cela, la face arrière 273 du substrat 232 est, par exemple, recouverte d'une couche électriquement conductrice 275. Plus précisément, la couche conductrice 275 est en contact avec le substrat 232. On a ainsi relié électriquement la face supérieure 233 du substrat à la borne de source 250. La liaison entre la face supérieure 233 du substrat 232 et la borne de source 250 comprend une liaison électrique, par exemple formée par divers éléments conducteurs, de préférence une impédance 270, plus préférentiellement une résistance. L'impédance 270 peut être, en partie ou en totalité, formée par le substrat 232.

Chaque transistor T1, T2 est configuré de sorte que, lorsqu'une tension positive est appliquée entre le drain et la source du transistor, l'état passant/bloqué du transistor est commandé par la tension entre la grille et la source du transistor. Ainsi, lorsque la tension prend des valeurs élevées telles que définies ci-dessus, la majeure partie de cette tension est entre le drain et la grille.

De préférence, comme ceci est représenté, les structures des interrupteurs 210-1 et 210-2 constituées par les couches 220 et 230, les grilles 240-1, 240-2 et les régions de drain 260-1, 260-2 et de source 250, sont symétriques l'une de l'autre par rapport à un plan ou par rapport à un axe passant par la région de source commune 250. Par symétrique, on entend symétrique à des dispersions de fabrication près. Ceci permet, par rapport à des interrupteurs 210-1 et 210-2 non symétriques, d'obtenir plus facilement dans et/ou sur un même support 232 plusieurs interrupteurs bidirectionnels 200 à région de source commune ayant des caractéristiques électriques identiques.

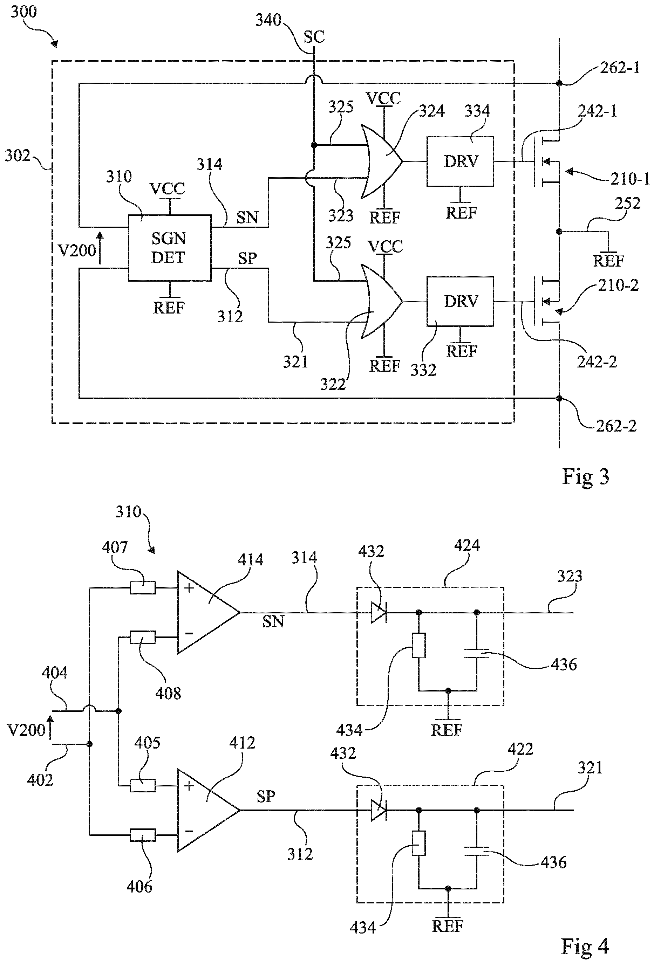

La figure 3 représente, de manière schématique, un mode de réalisation d'un dispositif 300 comprenant un circuit de commande 302 d'interrupteur bidirectionnel, relié à un interrupteur bidirectionnel comprenant des premier et deuxième interrupteurs électriquement en série. De préférence, les premier et deuxième interrupteurs sont identiques ou similaires aux interrupteurs respectifs 210-1 et 210-2 d'un interrupteur bidirectionnel 200 du type décrit en relation avec la figure 2. Les premier et deuxième interrupteurs sont alors en série entre les bornes 262-1 et 262-2 de l'interrupteur bidirectionnel.

Un convertisseur peut comprendre un, ou, de préférence, plusieurs, dispositifs tels que le dispositif 300. De préférence, une cellule de commutation telle que la cellule de commutation 100 décrite en relation avec la figure 1, ou branche du convertisseur, comprend deux dispositifs tel que le dispositif 300. En variante, dans tout dispositif usuel comprenant un ou plusieurs interrupteurs bidirectionnels, ce ou ces interrupteurs peuvent être remplacés par un dispositif tel que le dispositif 300.

De préférence, les premier et deuxième interrupteurs sont à effet de champ de même type, plus précisément, de même type N ou P de canal de conduction. Plus préférentiellement, les interrupteurs sont de type HEMT, et, encore plus préférentiellement, les interrupteurs sont de type HEMT à GaN à canal N. Dans le cas où les premier et deuxième interrupteurs sont à effet de champ de même type (type N ou type P) de conductivité de canal, les premier et deuxième interrupteurs ont, de préférence, une borne commune de source 252.

Le circuit de commande 302 comprend un circuit 310 (SGN DET) relié, de préférence connecté, aux bornes 262-1, 262-2 de l'interrupteur bidirectionnel. En fonctionnement, le circuit 310 reçoit la tension V200 présente entre les bornes 262-1 et 262-2 de l'interrupteur bidirectionnel. La tension V200 peut être successivement positive (potentiel de la borne 262-1 supérieur à celui de la borne 262-2) et négative (potentiel de la borne 262-2 supérieur à celui de la borne 262-1). A partir de la tension V200, le circuit 310 détecte un signe positif de la tension V200 et/ou détecte un signe négatif de la tension V200. Le circuit 310 détecte les deux signes, positif et négatif, de la tension V200. Le circuit 310 active un signal SP sur une sortie 312 lorsque le signe positif est détecté, et/ou le circuit 310 active un signal SN sur une sortie 314 lorsque le signe négatif est détecté. A titre d'exemple, le signal SP correspond à un niveau haut sur la sortie 312 et le signal SN correspond à un niveau haut sur la sortie 314.

Dans l'exemple représenté, la sortie 312 de signal SP de détection du signe positif est reliée, de préférence connectée, à une entrée 321 d'une porte logique OU 322. La porte OU 322 a une sortie reliée, de préférence connectée, à un circuit 332 d'attaque DRV (en anglais "driver"), encore appelé circuit de commande rapprochée, configuré pour appliquer le niveau de sortie de la porte OU 322 sur la borne de commande 242-2 de l'interrupteur 210-2. Le circuit d'attaque 332 met l'interrupteur 210-2 à l'état passant lorsque la sortie de la porte OU 322 est à un niveau haut. Ainsi, le circuit 302 maintient l'interrupteur 210-2 à l'état passant lorsque le signe positif est détecté, c'est-à-dire, à des temps de réaction près de la porte logique 322 et du circuit 332, pendant toute la durée des périodes auxquelles le signe positif est détecté par le circuit 310. En variante, le circuit 332 est omis, et son rôle est joué directement par la porte logique 322.

Dans l'exemple représenté, la sortie 314 de signal SN de détection du signe négatif est reliée, de préférence connectée, à une entrée 323 d'une porte logique OU 324. La porte OU 324 a une sortie reliée, de préférence connectée, à un circuit 334 d'attaque (DRV) configuré pour appliquer le niveau de sortie de la porte OU 324 sur la borne de commande 242-1 de l'interrupteur 210-1. Le circuit d'attaque 334 met l'interrupteur 210-1 à l'état passant lorsque la sortie de la porte OU 324 est à un niveau haut. Ainsi, le circuit 302 maintient l'interrupteur 210-1 à l'état passant lorsque le signe négatif est détecté, c'est-à-dire, à des temps de réaction près, pendant toute la durée des périodes auxquelles le signe négatif est détecté par le circuit 310. En variante, le circuit 334 est omis, et son rôle est joué directement par la porte logique 324.

L'exemple représenté n'est pas limitatif, les portes logiques 322 et 324, et les éventuels circuits 332 et 334 pouvant être remplacés par tout circuit ou ensemble de circuits configuré pour :
- maintenir le deuxième interrupteur à l'état passant lorsque le signe positif de la tension V200 est détecté par le circuit 310 ; et/ou
- maintenir le premier interrupteur à l'état passant lorsque le signe négatif de la tension V200 est détecté par le circuit 310.

Dans l'exemple représenté, les portes logiques 322 et 324 ont chacune une entrée 325 reliée, de préférence connectée, à une entrée 340 du circuit de commande 302. L'entrée 340 reçoit un signal de commande SC de l'interrupteur bidirectionnel. Le signal SC est typiquement constitué par un signal identique ou similaire aux signaux SCH et SCL décrits en relation avec la figure 1. Ainsi, le signal SC est préférentiellement un signal en créneaux, typiquement à une fréquence de découpage d'une cellule de commutation comprenant le dispositif 300. Les circuits d'attaque 332 et 334 appliquent le signal de commande SC aux interrupteurs respectifs 210-1 et 210-2. Plus précisément, lorsque le signe positif est détecté, le signal de commande SC est appliqué à l'interrupteur 210-1 pendant que l'interrupteur 210-2 est maintenu passant, ce qui permet de mettre l'interrupteur bidirectionnel 200 à l'un des états passant et bloqué uniquement en fonction du signal de commande SC. De même, lorsque le signe négatif est détecté, le signal de commande SC est appliqué à l'interrupteur 210-2 pendant que l'interrupteur 210-1 est maintenu passant, ce qui permet de mettre l'interrupteur bidirectionnel 200 à l'un des états passant et bloqué uniquement en fonction du signal de commande SC.

Cet exemple n'est pas limitatif, et les circuits définis ci-dessus pouvant remplacer les portes logiques 322 et 324 et les éventuels circuits 332 et 334 sont alors en outre, de préférence, configurés pour :
- appliquer le signal de commande SC au deuxième interrupteur lorsque le premier interrupteur est maintenu passant ; et/ou
- appliquer le signal de commande SC au premier interrupteur lorsque le deuxième interrupteur est maintenu passant.
Par rapport à une variante dans laquelle le circuit 302 reçoit des signaux de commande distincts pour les deux interrupteurs, ceci permet de commander l'interrupteur bidirectionnel de manière plus simple.

On aurait pu penser commander les deux interrupteurs simultanément avec la même commande SC sans maintenir l'un ou l'autre des interrupteurs à l'état passant. Dans ce cas, lorsque la commande SC est à un niveau commandant un blocage de l'interrupteur bidirectionnel, les premier et deuxième interrupteurs seraient alors simultanément bloqués. Le noeud de connexion entre les premier et deuxième interrupteurs (défini par la borne commune de source 252 dans l'exemple représenté) serait à un potentiel flottant, ce qui aurait posé divers problèmes. En particulier dans l'exemple d'interrupteurs 210-1 et 210-2 comprenant des transistors à effet de champ sur un substrat tel que le substrat 232 décrit en relation avec la figure 2, ceci aurait posé des problèmes d'accumulation de charges dans la partie du substrat 232 proche de la face 233 sous les transistors T1 et T2. Une telle accumulation de charges provient typiquement du découpage des tensions élevées telles que définies ci-dessus. Cette accumulation de charges aurait été susceptible de modifier les seuils de tension grille-source au-delà desquels les transistors sont passants, et/ou d'augmenter la résistance à l'état passant de l'interrupteur bidirectionnel.

Par rapport à un procédé dans lequel la commande SC serait appliquée simultanément aux interrupteurs 210-1 et 210-2 sans maintien à l'état passant de l'un des interrupteurs, les modes de réalisation du procédé mis en oeuvre par le circuit 302 présentent l'avantage de fixer le potentiel du noeud de connexion entre les premier et deuxième interrupteurs. Plus précisément, le potentiel du noeud de connexion (borne 252) entre interrupteurs 210-1 et 210-2 est maintenu égal au potentiel de l'une des bornes 262-1 et 262-2 de l'interrupteur bidirectionnel. Dans le cas de transistors à effet de champ à canal N tels que ceux des interrupteurs 210-1 et 210-2, le potentiel de la borne commune de source 252 est rendu égal au potentiel le plus bas parmi les potentiels des bornes 262-1 et 262-2 de l'interrupteur bidirectionnel. En particulier, dans le cas des interrupteurs 210-1 et 210-2 comprenant des transistors à effet de champ sur un même substrat (par exemple des transistors de type HEMT à GaN) ayant une borne commune de source reliée au substrat, on évite que les seuils de tension de mise à l'état passant des interrupteurs 210-1 et 210-2 et/ou la résistance à l'état passant des interrupteurs 210-1 et 210-2 soit affectés par des accumulations de charges.

La mise à l'état passant de l'interrupteur 210-1 lorsque le signe négatif de la tension V200 est détecté, connecte entre elles les bornes 252 et 262-1 de l'interrupteur 210-1. Ces bornes 252 et 262-1, connectées entre elles lorsque l'interrupteur 210-1 est passant, constituent des bornes de conduction de l'interrupteur 210-1. De même, la mise à l'état passant de l'interrupteur 210-2 lorsque le signe positif de la tension V200 est détecté, connecte entre elles les bornes de conduction 252 et 262-2 de l'interrupteur 210-2.

L'avantage décrit ci-dessus d'éviter les accumulations de charges résulte de la connexion des bornes de conduction entre elles de l'un ou l'autre des interrupteurs 210-1 et 210-2. On pourrait penser éviter les accumulations de charge en prévoyant un circuit supplémentaire relié au noeud 252 pour appliquer un potentiel à ce noeud. Par rapport à un dispositif comprenant un tel circuit supplémentaire, le noeud de connexion 252 peut-être relié seulement au circuit de commande 302, ce qui simplifie le dispositif 300.

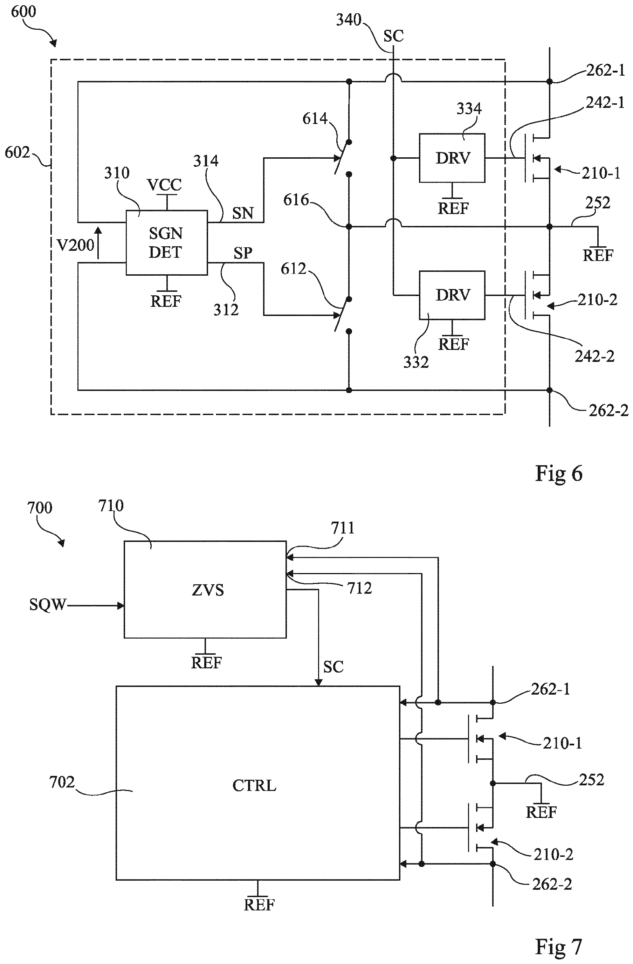

Par rapport à un procédé dans lequel les bornes d'aucun des interrupteurs 210-1 et 210-2 ne seraient connectées entre elles lorsque qu'une tension élevée est présente aux bornes de l'interrupteur bidirectionnel, on obtient un fonctionnement plus fiable et un rendement énergétique plus élevé. Selon un mode de réalisation décrit ci-après en relation avec la figure 6, ceci peut également être obtenu par des interrupteurs supplémentaires électriquement en parallèle. Ces interrupteurs supplémentaires sont capables de supporter la tension élevée aux bornes de l'interrupteur bidirectionnel. Par rapport au mode de réalisation de la figure 6, le fait de maintenir l'interrupteur 210-1 ou 210-2 à l'état passant lorsque la tension est élevée aux bornes de l'interrupteur bidirectionnel permet d'éviter la mise en oeuvre de ces interrupteurs supplémentaires.

On aurait aussi pu penser, dans le cas d'un interrupteur bidirectionnel compris dans une cellule de commutation, détecter le signe de la tension aux bornes de la cellule de commutation, et commander les premier et deuxième interrupteurs de l'interrupteur bidirectionnel à partir de la tension aux bornes de la cellule de commutation, par exemple en déduisant le signe de la tension aux bornes de l'interrupteur bidirectionnel à partir de celui de la tension aux bornes de la cellule de commutation. Cependant, par rapport à un tel procédé de commande, le fait de recevoir directement la tension présente entre les bornes de l'interrupteur bidirectionnel, et de détecter le signe de la tension aux bornes de l'interrupteur bidirectionnel à partir de cette tension directement reçue, permet d'éviter d'avoir à relier le circuit de commande 302 à la fois aux deux bornes de la cellule de commutation. Le fait d'éviter des liaisons entre le circuit de commande 302 et les deux bornes de la cellule de commutation, permet de simplifier l'utilisation du circuit 302 dans une cellule de commutation, par rapport à un circuit de commande prévu pour être connecté à la fois aux deux bornes de la cellule de commutation. Ceci permet de simplifier la réalisation de la cellule de commutation, et donc du convertisseur.

Selon un mode de réalisation, le circuit 302 est monolithique, c'est-à-dire que tous ses circuits sont des circuits intégrés dans et sur un même support, typiquement dans et sur une même portion de tranche semiconductrice. Un tel circuit intégré monolithique est, de préférence, situé dans un boîtier de circuit intégré. Par boîtier de circuit intégré, on entend un ensemble, de préférence étanche, d'où sortent des plages de connexion ou des broches de connexion à des circuits électroniques extérieurs au boîtier, par exemple à un circuit imprimé, PCB (en anglais "Printed Circuit Board") .

En particulier, on peut alors prévoir que l'ensemble du dispositif 300, comprenant le circuit 302 et les interrupteurs 210-1 et 210-2, soit dans un même boîtier, par exemple sur un même support (dispositif 300 monolithique) ou sur des supports différents. Ceci permet de fabriquer la cellule de commutation de manière particulièrement simple.

De préférence, le circuit 302 est alimenté par une tension VCC, préférentiellement continue, référencée par rapport au potentiel REF de la borne commune de source 252. Dans l'exemple représenté, le circuit de détection de signe 310 et les portes logiques 322 et 324 sont alimentés par la tension VCC (référencée par rapport au potentiel REF). En outre, les circuits d'attaque 334 et 332 sont référencés par rapport au potentiel REF afin d'appliquer aux bornes de commandes respectives 242-1 et 242-2 des potentiels de commande référencés par rapport au potentiel REF.

Dans une variante non couverte par les revendications, le circuit de détection de signe 310 et les portes logiques 322 et 324 sont référencés par rapport à un ou plusieurs autres potentiels, par exemple celui de l'une des bornes de l'interrupteur bidirectionnel. Cependant, par rapport à une telle variante, le fait de référencer le circuit 302 par rapport au potentiel REF permet d'éviter une adaptation de niveau de potentiel pour commander les interrupteurs 210-1 et 210-2. Ceci est d'autant plus avantageux que la tension entre bornes de drain 262-1, 262-2 et de source commune 252 prend alternativement, à la fréquence de découpage, les valeurs élevées définies ci-dessus et des valeurs sensiblement nulles par rapport à ces valeurs élevées. On évite alors les difficultés de mise en oeuvre d'une adaptation de niveau de potentiel, ainsi que les retards dans l'application de la commande SC qui résulteraient de l'adaptation de niveau de potentiel.

Selon un mode de réalisation, la tension VCC est fournie par un circuit, non représenté, compris dans le circuit 302 et alimenté uniquement à partir de la tension variable présente entre les bornes 262-1 et 262-2. Ainsi, le circuit de commande 302 de l'interrupteur bidirectionnel peut, en dehors de l'entrée 340 de la commande SC, être relié, de préférence connecté, uniquement à la borne commune de source 252, aux bornes de drain 262-1 et 262-2, et aux bornes de commandes 242-1 et 242-2 de l'interrupteur bidirectionnel. La fabrication d'une cellule de commutation, d'un convertisseur ou de tout dispositif comprenant le dispositif 300 est alors particulièrement simple, et la mise en oeuvre du dispositif 300 est, elle aussi, particulièrement simple.

La figure 4 représente, de manière schématique, un exemple d'un mode de réalisation d'une partie du circuit de commande 302 du dispositif de la figure 3. Dans ce mode de réalisation, on prévoit que les sorties 312 et 314 du circuit 310 de détection de signe soient reliées aux entrées respectives 321 et 323 des portes logiques respectives 322 et 324 (ou aux entrées d'un circuit jouant le rôle des portes logiques 322 et 324 et des circuits 334 et 332) par des détecteurs d'enveloppe 422 et 424.

Le circuit de détection 310 comprend une entrée constituée de deux noeuds d'entrée, 402 et 404, reliés, de préférence connectés, aux bornes 262-1 et 262-2 (figure 3) de l'interrupteur bidirectionnel. Ainsi, les noeuds d'entrée 404 et 402 reçoivent la tension V200 présente entre les bornes de l'interrupteur bidirectionnel.

Dans l'exemple représenté, le circuit de détection 310 comprend :
- un comparateur 412 ayant une entrée inverseuse (-) reliée, de préférence par une résistance 406, au noeud 402 et une entrée non inverseuse (+) reliée, de préférence par une résistance 405, au noeud 404 ; et
- de préférence, un comparateur 414 ayant une entrée non inverseuse (+) reliée, de préférence par une résistance 407, au noeud 402, et une entrée inverseuse (-) reliée, de préférence par une résistance 408, au noeud 404.

Les sorties de comparateurs 412 et 414 constituent les sorties respectives 312 et 314 du circuit 310.

Dans l'exemple représenté, le circuit de commande 302 (figure 3) comprend en outre :
- un détecteur d'enveloppe 422 ayant une entrée reliée, de préférence connectée, à la sortie 312, et une sortie reliée, de préférence connectée, à l'entrée 321 de la porte logique 322 (figure 3) ; et/ou
- un détecteur d'enveloppe 424 ayant une entrée reliée, de préférence connectée, à la sortie 314, et une sortie reliée, de préférence connectée, à l'entrée 323 de la porte logique 324 (figure 3).

Autrement dit, le comparateur 412 et le détecteur d'enveloppe 422 sont en série entre, d'un côté, les noeuds d'entrée 402 et 404, et, de l'autre côté, l'entrée 321. De même, le comparateur 414 et le détecteur d'enveloppe 424 sont en série entre, d'un côté, les noeuds d'entrée 402 et 404, et, de l'autre côté, l'entrée 323.

Les détecteurs d'enveloppe 422 et 424 sont chacun défini par :
- une diode 432 reliant l'entrée du détecteur d'enveloppe à un noeud de sortie du détecteur d'enveloppe (c'est-à-dire, respectivement, l'entrée 321 ou 323). A titre d'exemple, la diode 432 a sa cathode située du côté de la sortie du détecteur d'enveloppe ; et
- un élément résistif 434 et un élément capacitif 436 en parallèle entre la sortie du détecteur d'enveloppe et un noeud relié, de préférence connecté, à la borne commune de source 252 (figure 3, au potentiel REF).

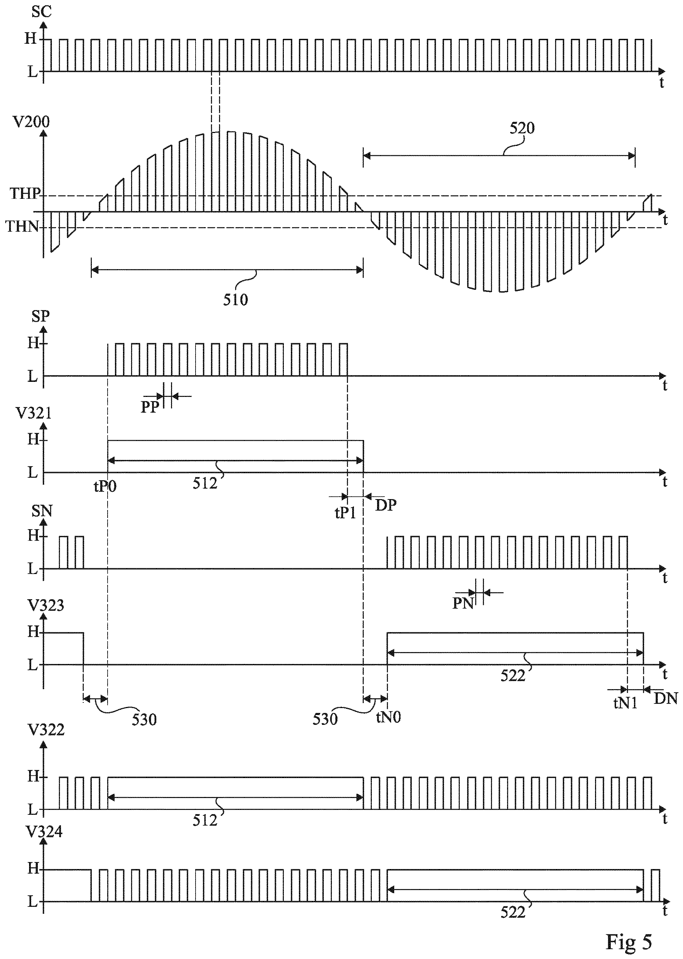

La figure 5 représente, de manière schématique et sous forme de chronogrammes, un mode de réalisation d'un procédé mis en oeuvre par le circuit de commande 302 de la figure 3. En particulier, le procédé est ici mis en oeuvre dans le cas de l'exemple de la figure 4, le dispositif 300 de la figure 3 étant utilisé dans une cellule de commutation telle que la cellule 100 de la figure 1. Plus précisément, on a représenté, en fonction du temps t, des allures schématiques de :
- le signal SC de commande de l'interrupteur bidirectionnel, reçu sur l'entrée 340 du circuit 302 ;
- la tension V200 aux bornes de l'interrupteur bidirectionnel ;
- le signal SP de détection du signe positif de la tension V200 ;
- un niveau V321 de sortie du détecteur d'enveloppe 422 ;
- le signal SN de détection du signe négatif de la tension V200 ;
- un niveau V323 de sortie du détecteur d'enveloppe 424 ;
- un niveau V322 de sortie de la porte logique 322 ; et
- un niveau V324 de sortie de la porte logique 324.

Dans cet exemple, le signal SC est en créneaux entre un niveau haut (H) et un niveau bas (L). La tension aux bornes de la cellule de commutation est alternative et sinusoïdale. Par souci de lisibilité, le rapport représenté entre la fréquence des créneaux du signal SC (fréquence de découpage) et la fréquence de la tension aux bornes de la cellule de commutation, est réduit par rapport aux rapports typiques entre ces fréquences.

Lorsque le signal SC est au niveau haut, l'interrupteur bidirectionnel est passant, et la tension aux bornes de l'interrupteur bidirectionnel est, par rapport à la valeur crête de la tension alternative, sensiblement nulle. Lorsque le signal SC est au niveau bas, l'interrupteur bidirectionnel est bloqué, et la tension alternative aux bornes de la cellule de commutation se retrouve aux bornes de l'interrupteur bidirectionnel.

De préférence, le signe positif de la tension V200 est détecté lorsque la tension franchit un seuil THP de détection du signe positif. Après franchissement du seuil THP, le signe positif reste détecté au moins tant que la tension est supérieure au seuil THP. Ainsi, le signal SP de détection est activé (niveau haut H) pendant des périodes PP où la tension V200 est positive et supérieure au seuil THP. Dans l'exemple représenté, le signal de détection SP est désactivé (niveau bas L) en dehors de ces périodes.

De préférence, le signe négatif de la tension V200 est détecté lorsque la tension est négative et franchit, en valeur absolue, un seuil THN de détection du signe négatif. Après franchissement du seuil THN, le signe négatif reste détecté au moins tant que la tension est négative et, en valeur absolue, supérieure au seuil THN. Ainsi, le signal SN de détection est activé (niveau haut H) pendant des périodes PN où la tension V200 est négative et supérieure, en valeur absolue, au seuil THN. Dans l'exemple représenté, le signal de détection SN est désactivé (niveau bas L) en dehors de ces périodes.

Le fait de prévoir que le signe positif et/ou négatif soit détecté seulement lorsque la tension V200 est, en valeur absolue, supérieure à un seuil, permet d'éviter tout risque de détecter en même temps un signe positif et un signe négatif de la tension V200 lorsque la tension V200 est proche de zéro, plus particulièrement lorsque la tension alternative appliquée à la cellule de commutation est proche de zéro. On évite ainsi que les interrupteurs 210-1 et 210-2 soient maintenus passants en même temps indépendamment du niveau du signal de commande SC, en particulier lorsque le signal SC est au niveau bas commandant de bloquer l'interrupteur bidirectionnel. On évite ainsi que l'interrupteur bidirectionnel reste passant lorsque la commande SC requiert qu'il soit bloqué. On évite ainsi un risque que, dans une cellule de commutation, deux interrupteurs bidirectionnels soient passants en même temps.

En variante, on peut prévoir, en complément ou en remplacement du ou des seuils de détection des signes, des circuits logiques usuels configurés pour interdire la commande simultanée à l'état passant des deux interrupteurs 210-1 et 210-2. L'homme du métier saura insérer de tels circuits logiques entre les sorties des portes logiques 324 et 322 et les interrupteurs 210-1 et 210-2.

De préférence, le détecteur d'enveloppe 422 est de sorte que, après la fin de chaque période PP, le niveau appliqué à l'entrée 321 de la porte logique 322 reste, pendant un délai DP, supérieur à un seuil de détection d'un niveau logique haut d'entrée de la porte logique 322. Le délai DP est supérieur à une durée entre les créneaux pendant lesquels le signal SC est à son niveau haut. De préférence, le délai DP est supérieur au temps de cycle du signal SC. Ainsi, pour chaque période 510 pendant laquelle la tension alternative appliquée à la cellule de commutation est positive, le niveau V321 prend la valeur haute (H) à un instant tP0 où le seuil THP est franchi par la tension V200 en début de période 510. A partir de l'instant tP0, le signal SP est en créneaux jusqu'à un instant tP1 correspondant au retour de la tension alternative à une valeur inférieure au seuil THP en fin de période 510. Le niveau V321 reste haut pendant une période 512 qui débute à l'instant tP0 et se termine lorsque le délai DP est écoulé à partir de l'instant tP1. Le niveau V321 a la valeur basse (L) en dehors des périodes 512. Ainsi, dans cet exemple, le comparateur 412 fonctionne à la fréquence de découpage, et le détecteur d'enveloppe 422 produit, sur sa sortie, un signal tout ou rien à la fréquence de la tension alternative aux bornes de la cellule de commutation.

De préférence, le circuit détecteur d'enveloppe 424 est de sorte que, après la fin de chaque période PN, le niveau appliqué à l'entrée 323 de la porte logique 324 reste, pendant un délai DN, supérieur à un seuil de détection d'un niveau logique haut d'entrée de la porte logique 324. Le délai DN est supérieur à une durée entre les créneaux pendant lesquels le signal SC a son niveau haut. De préférence, le délai DN est supérieur au temps de cycle du signal SC. Ainsi, à chaque période 520 pendant laquelle la tension alternative appliquée à la cellule de commutation est négative, le niveau V323 prend la valeur haute à un instant tN0 où le seuil THN est franchi, en valeur absolue, par la tension V200 en début de période 520. A partir de l'instant tN0, le signal SN est en créneaux jusqu'à un instant tN1 correspondant au retour de la tension alternative à une valeur inférieure, en valeur absolue, au seuil THN en fin de période 520. Le niveau V323 reste haut pendant une période 522 qui se termine lorsque le délai DN est écoulé à partir de l'instant tN1. Le niveau V323 a la valeur basse (L) en dehors des périodes 522. Ainsi, dans cet exemple, le comparateur 414 fonctionne à la fréquence de découpage, et le détecteur d'enveloppe 424 produit, sur sa sortie, un signal tout ou rien à la fréquence de la tension alternative aux bornes de la cellule de commutation.

L'interrupteur 210-1 est mis aux états respectifs passant et bloqué lorsque le niveau V324 est aux niveaux respectifs haut et bas. L'interrupteur 210-2 est mis aux niveaux respectifs passant et bloqué lorsque le niveau V322 est aux niveaux respectifs haut et bas.

On maintient ainsi l'interrupteur 210-2 à l'état passant, non seulement pendant chaque période PP, mais aussi pendant le délai DP après la fin de chaque période PP, et/ou on maintient à l'état passant l'interrupteur 210-1, non seulement pendant chaque période PN, mais aussi pendant le délai DN après la fin de chaque période PN. Ceci permet de maintenir l'interrupteur 210-2 à l'état passant sans interruption pendant la totalité de chaque période 512, et/ou de maintenir l'interrupteur 210-1 à l'état passant sans interruption pendant la totalité de chaque période 522.

En variante, les détecteurs d'enveloppe 422 et 424 peuvent être omis. Les signaux SP et SN sont alors appliqués directement aux entrées des portes logiques respectives 322 et 324. Dans ce cas, pour chaque créneau du signal de commande SC, les interrupteurs 210-1 et 210-2 sont maintenus passants par application du signal SC aux interrupteurs, et, entre les créneaux, l'un ou l'autre des interrupteurs 210-1 et 210-2 est maintenu passant en fonction du signe détecté par le circuit 310. Cependant, par rapport au cas où les détecteurs ou circuits d'enveloppe sont omis, le fait de :
- maintenir à l'état passant l'interrupteur 210-1 pendant le délai DN après la fin de chaque période PN ; et/ou
- maintenir à l'état passant l'interrupteur 210-2 pendant le délai DP après la fin de chaque période PP,
présente l'avantage d'éviter que, à la fin de chaque créneau de niveau haut du signal SC, l'interrupteur 210-1 ou 210-2 maintenu passant en fonction du signe détecté soit bloqué temporairement entre l'instant où le signal SC passe au niveau bas et l'instant où la tension V200 franchit le seuil de détection. On évite ainsi diverses pertes de rendement énergétique et divers risques pour la fiabilité de fonctionnement.

Bien que les délais DP et DN décrits ci-dessus soient obtenus avec un détecteur d'enveloppe particulier, les délais DN et DP peuvent être obtenus par tout détecteur d'enveloppe. Le détecteur d'enveloppe peut être remplacé par tout circuit usuel permettant de prolonger une période par un délai donné, par exemple un circuit monostable.

De préférence, les délais DP et DN, et les seuils THP et THN, sont prévus pour que les périodes 512 et 522 ne se recouvrent pas. A titre d'exemple, on prévoit des périodes 530 entre la fin de chaque période 512, 522 et le début de la période respective 522, 512 suivante. On évite ainsi tout risque que les interrupteurs 210-1 et 210-2 soient maintenus simultanément à l'état passant lorsque le signal de commande SC est au niveau bas.

Dans le procédé décrit ci-dessus, l'interrupteur 210-1 est maintenu à l'état passant pendant les périodes 522, et le signal SC est appliqué à la borne de commande de l'interrupteur 210-1 uniquement en dehors des périodes 522. De même, l'interrupteur 210-2 est maintenu à l'état passant pendant les périodes 512, et le signal SC est appliqué à la borne de commande de l'interrupteur 210-2 uniquement en dehors des périodes 512. Ainsi, pendant les périodes 530, le signal de commande SC est appliqué simultanément aux deux interrupteurs 210-1 et 210-2, ce qui permet de commander l'état de l'interrupteur bidirectionnel avec le seul signal SC. De préférence, les délais DP et DN, et les seuils THP et THN sont choisis pour que les périodes 530 aient une durée inférieure à 10 %, de préférence inférieure à 1 %, plus préférentiellement inférieure à 0,1% de la durée d'un cycle de la tension alternative appliquée à la cellule de commutation (cette durée est la somme des durées des périodes 510 et 520). Pour cela, à titre d'exemple, les délais DP et DN sont par exemple inférieurs à 0,5 ms, plus préférentiellement inférieurs à 0,1 ms, et les seuils THP et THN sont inférieurs à 50 V, de préférence inférieurs à 10 V. De tels délais sont plus particulièrement avantageux pour la tension d'entrée d'un réseau de distribution électrique, par exemple environ 230 V efficace et 50 Hz. A partir de cet exemple, l'homme du métier saura définir les délais en fonction de la tension efficace et de la fréquence de la tension alternative appliquée à la cellule de commutation.

On a décrit ci-dessus, en relation avec les figures 4 et 5, un exemple particulier de dispositif, dans lequel, pour chaque signe positif et négatif, le comparateur respectif 412, 414 et le détecteur d'enveloppe respectif 422, 424 sont en série dans un ordre particulier entre, d'un côté, les noeuds d'entrée 402 et 404, et, de l'autre côté, l'entrée respective 321 ou 323. Cependant, il est possible, pour chaque signe, d'échanger les positions du comparateur et du détecteur d'enveloppe en série. Ainsi, pour chaque signe, le détecteur d'enveloppe est du côté des noeuds d'entrée 402 et 404, et le comparateur est du côté de l'entrée respective 321 ou 323. Dans ce cas, de même que précédemment, les signes positif et négatif sont détectés au moins pendant les périodes respectives PP, PN, où la tension V200 est supérieure, en valeur absolue, au seuil respectif THP, THN. Le fonctionnement diffère du fonctionnement de l'exemple de la figure 4 essentiellement en ce que les signes positif et négatif sont détectés non seulement pendant les périodes respectives PP et PN, mais aussi pendant un délai respectif DN, DP après ces périodes. Par rapport au fonctionnement de l'exemple de la figure 4, cette différence ne modifie pas les commandes appliquées aux interrupteurs 210-1 et 210-2, à savoir :
- l'interrupteur 210-2 est maintenu passant pendant les périodes 512 ;
- l'interrupteur 210-1 est maintenu passant pendant les périodes 522 ;
- le signal de commande SC est appliqué à l'interrupteur 210-2 en dehors des périodes 512 ; et
- le signal de commande SC est appliqué à l'interrupteur 210-1 en dehors des périodes 522.

La figure 6 représente, de manière schématique, un autre mode de réalisation d'un dispositif 600 comprenant un circuit 602 de commande d'interrupteur bidirectionnel, relié à un interrupteur bidirectionnel comprenant des premier et deuxième interrupteurs, 210-1 et 210-2, en série.

Le dispositif 600 et le circuit 602 reprennent des éléments identiques ou similaires à ceux du dispositif 300 et du circuit 302 de la figure 3. Ces éléments ne sont pas décrits ici à nouveau en détail. Seules les différences sont mises en exergue. Un convertisseur peut comprendre un ou plusieurs dispositifs tel que les dispositifs 300 et 600. On peut prévoir que l'ensemble du dispositif 600 soit dans un même boîtier, par exemple qu'il soit monolithique.

Le dispositif 600 diffère du dispositif 300 de la figure 3 en ce que le circuit 302 est remplacé par le circuit 602. Le circuit 602 diffère du circuit 302 de la figure 3 en ce que les portes OU 322 et 324 ont été remplacées par deux interrupteurs supplémentaires respectifs 612 et 614. L'interrupteur supplémentaire 612 est électriquement en parallèle du deuxième interrupteur 210-2. L'interrupteur supplémentaire 614 est électriquement en parallèle du deuxième interrupteur 210-2. Autrement dit, chacun des interrupteurs supplémentaires, respectivement 612 et 614, relie entre elles les bornes de conduction des interrupteurs respectifs 210-2, 210-1. Ainsi, un noeud 616 de connexion en série des interrupteurs supplémentaires 612 et 614 est relié, de préférence connecté, à la borne commune de source 252.

Les interrupteurs 612 et 614 sont commandés par les signaux respectifs SN et SP fournis par le circuit 310 de détection de signe. Les circuits d'attaque 332 et 334 reçoivent le signal SC à appliquer aux interrupteurs respectifs 210-1 et 210-2.

En fonctionnement, l'interrupteur 612 est passant pendant toute la durée des périodes pendant lesquelles le signe positif de la tension V200 est détecté par le circuit 310. L'interrupteur 614 est passant pendant toute la durée des périodes pendant lesquelles le signe négatif de la tension V200 est détecté par le circuit 310. Le circuit 602 de la figure 6 peut donc mettre en oeuvre un procédé identique ou similaire à celui mis en oeuvre par le circuit 302 de la figure 3, par exemple tel que décrit en relation avec la figure 5, à la différence que :
- lorsque le signe positif est détecté, la connexion entre les bornes de l'interrupteur 210-2 est effectuée par l'interrupteur 614. L'état de l'interrupteur 210-2 est alors, de préférence, alternativement passant et non passant à la fréquence de découpage ; et
- lorsque le signe négatif est détecté, la connexion entre les bornes de l'interrupteur 210-1 est effectuée par l'interrupteur 612. L'état de l'interrupteur 210-1 est alors, de préférence, alternativement passant et non passant à la fréquence de découpage.

Comme mentionné précédemment, comme pour le mode de réalisation de la figure 3, on évite ainsi que les seuils de tension de mise à l'état passant des interrupteurs 210-1 et 210-2 et/ou la résistance à l'état passant des interrupteurs 210-1 et 210-2 soit affectés par des accumulations de charges.

De préférence, les interrupteurs 614 et 612 sont des transistors à effet de champ, typiquement des transistors de même nature que les transistors 210-1 et 210-2.

Les applications visées par la présente description sont des applications de puissance. En d'autres termes, les transistors 210-1 et 210-2 et les interrupteurs 614 et 612 sont dimensionnés pour des puissances de plusieurs Watts, typiquement supérieures à 10 Watts. Par ailleurs, s'agissant d'un convertisseur de puissance, la fréquence de découpage de la tension V200 opérée par les transistors 210-1 et 210-2 est de quelques MHz, typiquement inférieure à 10 MHz, tout en restant supérieure, dans un rapport d'au moins 100, à la fréquence de commutation des interrupteurs 612 et 614.

Selon un exemple particulier de réalisation, la fréquence de commutation des transistors 612 et 614 correspond à la fréquence de la tension alternative V200, par exemple la tension du réseau de distribution électrique, tandis que la fréquence de commutation des transistors 210-1 et 210-2 est de plusieurs kHz (en restant inférieur à 10 MHz) et est choie en fonction de la fréquence de découpage souhaitée dans l'application visée.

Les problématiques de telles applications de puissance sont particulières. En particulier, les résistances à l'état passant des interrupteurs 210-1, 210-2, 612 et 614 doivent être compatibles avec une faible dissipation, donc rester faibles, mais surtout être symétriques dans une même branche. En d'autres termes, la résistance à l'état passant du transistor 210-1 est approximativement identique, de préférence identique, à celle du transistor 210-2. De même la résistance à l'état passant du transistor 614 est approximativement identique, de préférence identique, à celle du transistor 612. Encore plus préférentiellement, tous les transistors 210-1, 210-2, 612 et 614 présentent des résistances à l'état passant approximativement identiques, de préférence identiques. Ainsi, les géométries (rapport W/L, c'est-à-dire largeur sur longueur de grille) des transistors constitutifs des interrupteurs 210-1, 210-2, 612, 614 sont, au moins pour les transistors d'une même branche, approximativement identiques, de préférence identiques.

Avec des géométries identiques, le courant dans chaque transistor d'une branche donnée est identique au courant traversant l'autre transistor de la même branche alors même que leur conduction n'est pas simultanée. Cela participe à l'équilibre de la puissance transférée dans les alternances positives et négatives de la tension alternative convertie. Cela distingue notamment la structure décrite de structures qui seraient susceptibles d'exister pour des applications très hautes fréquences (de l'ordre de la centaine de MHz) et basse puissance (de l'ordre de quelques Watts) où des écarts entre les résistances à l'état passant de transistors en série peuvent être recherchées.

Une caractéristique des modes de réalisation décrits, et plus particulièrement du mode de réalisation de la figure 6, est d'analyser la polarité de la tension V200 pour organiser la commutation des transistors 612 et 614. Cette analyse par le détecteur 310 est effectuée au cours du fonctionnement du dispositif 600 et du système dans lequel il est intégré. Il ne s'agit pas d'une configuration effectuée à la conception ou au montage du circuit dans son environnement applicatif, mais bien d'une détection permanente lorsque le système dans lequel est intégré le circuit est en fonctionnement.

Une autre caractéristique des modes de réalisation décrits est que les signaux de commande, fournis par le détecteur 310 pour les transistors 612 et 614 et par les circuits 332 et 334 pour les transistors 210-2 et 210-1, sont tous référencés au potentiel Vref, c'est-à-dire au potentiel des sources des transistors 210-2 et 210-1 et, de préférence des transistors 612 et 614.

La figure 7 représente, de manière très schématique, encore un autre mode de réalisation d'un dispositif 700 comprenant un circuit 702 (CTRL) de commande d'interrupteur bidirectionnel, relié à un interrupteur bidirectionnel comprenant des premier et deuxièmes interrupteurs, respectivement 210-1 et 210-2. Le circuit 702 peut-être identique ou similaire au circuit 302 de la figure 3 ou au circuit 602 de la figure 6. Le dispositif 700 est alors identique ou similaire au dispositif 300 de la figure 3 ou au dispositif 600 de la figure 6.

Le dispositif 700 comprend en outre un module 710 de commande de commutation à tension nulle ZVS (en anglais "Zéro Voltage Switching"). Le dispositif 700 fournit le signal SC de commande de l'interrupteur bidirectionnel. Le module 710 reçoit la tension entre les bornes de l'interrupteur bidirectionnel sur des entrées 711 et 712 reliées, de préférence connectées, aux bornes respectives 262-1 et 262-2 de l'interrupteur bidirectionnel. Le module 710 reçoit un signal de commande SQW, de préférence en créneaux. Le signal SQW peut être identique ou similaire aux signaux SCH et SCL décrits en relation avec la figure 1. Le signal SC fourni par le module 710 est référencé par rapport au potentiel REF de la borne 252 commune de source. Autrement dit, le module 710 est relié, de préférence connecté, à la borne commune de source 252.

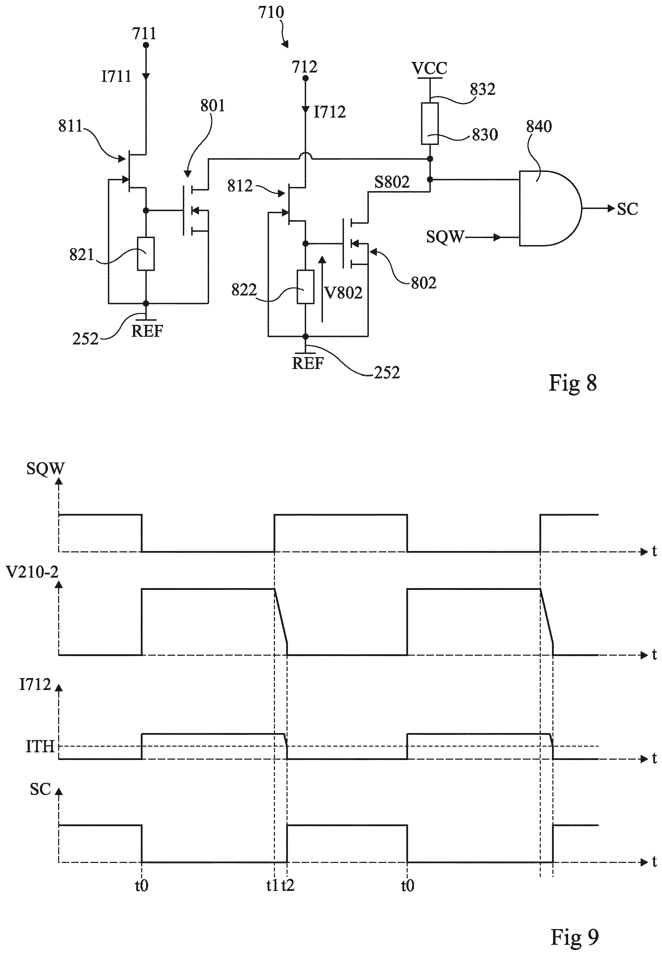

La figure 8 représente, de manière schématique, un mode de réalisation du module 710 du circuit de la figure 7.

Le module 710 comprend un transistor 802, par exemple à effet de champ à canal N. Le transistor 802 a une borne de source reliée, de préférence connectée, à la borne commune de source 252 dont le potentiel REF sert de référence pour le module 710.

Le module 710 comprend en outre un transistor 812, de préférence de type à effet de champ et passant lorsque la tension de commande grille-source est nulle. Un tel transistor peut être à effet de champ à canal N à jonction JFET (en anglais, "Junction Field Effect Transistor"). Le transistor 812 a une borne de drain reliée, de préférence connectée, à l'entrée 712 du module 710. La borne de grille ou de commande du transistor 812 est reliée, de préférence connectée, à la borne commune de source 252.

Le module 710 comprend en outre un élément résistif 822. Un tel élément résistif peut être constitué par une résistance ou par plusieurs résistances en série et/ou en parallèle. L'élément résistif 822 relie la borne de grille (borne de commande) du transistor 802 à la borne commune de source 252.

Le module 710 comprend en outre un élément résistif 830. L'élément résistif 830 relie, de préférence connecte, la borne de drain du transistor 802 à un noeud 832 d'application d'une tension d'alimentation, de préférence la tension VCC d'alimentation du circuit 310 (figure 3).

Le module 710 comprend une porte logique ET 840. La porte ET 840 a une entrée reliée, de préférence connectée, au drain du transistor 802. La porte logique ET est alimentée, de préférence, par la tension VCC référencée au potentiel VREF (non représenté).

En fonctionnement, dans la partie du module 710 décrite ci-dessus, le transistor JFET 812 constitue une source d'une tension V802 de commande du transistor 802. En variante, le transistor JFET 812 peut être remplacé par tout élément apte à former une source de tension alimentée par la tension entre l'entrée 712 et la borne 252.

L'élément résistif 822 constitue une charge alimentée par la tension V802. Cette charge provoque le passage d'un courant entre la borne de grille du transistor 802 et la borne commune de source 252. Il en résulte un courant 1712 provenant de la borne 262-2 (figure 7) de l'interrupteur 210-2 (figure 7), entrant par l'entrée 712, passant par le transistor 812 et l'élément résistif 822, et rejoignant la borne 252. Autrement dit, le courant I712 est en parallèle entre les bornes du deuxième interrupteur 210-2. En variante, l'élément résistif 822 peut être remplacé par n'importe quelle charge apte à être traversée par un courant lorsqu'une tension est appliquée à ses bornes.

Le transistor 802 a une tension de seuil. Lorsque la tension V802 de commande est supérieure à la tension de seuil du transistor 802, le transistor 802 est à l'état passant. Ceci se produit lorsque le courant I712 a une valeur supérieure à un seuil de courant ITH. Lorsque la tension V802 est inférieure à la tension de seuil du transistor 802, le transistor 802 est à l'état bloqué. Ceci se produit lorsque le courant I712 a une valeur inférieure au seuil de courant ITH.

L'élément résistif 830 permet d'alimenter un signal S802 fourni sur le drain du transistor 802. Le signal S802 est fonction de l'état bloqué/passant du transistor 802. Autrement dit, le transistor 802 est configuré pour fournir le signal S802. L'élément résistif 830 peut être remplacé par tout élément permettant au transistor 802 de fournir un signal.

Dans l'exemple représenté, le signal S802 est au niveau bas lorsque le transistor 802 est passant. En variante, le transistor 802 et l'élément résistif 830 peuvent être remplacés par n'importe quel circuit permettant de comparer le courant I712 au seuil de courant ITH et de fournir un signal représentatif du résultat de la comparaison.

Lorsque le signal S802 est au niveau bas, le signal SC fourni par la porte ET 840 reste au niveau bas quel que soit le niveau du signal de commande SQW. Lorsque le signal S802 est au niveau haut, le signal SC fourni par la porte ET 840 prend le niveau du signal de commande SQW. Autrement dit, le signal S802 constitue un signal d'autorisation, pour le signal de commande SC, de prendre un état de mise à l'état passant de l'interrupteur bidirectionnel.

De préférence, le module 710 comprend en outre :
- un transistor 801, de préférence identique ou similaire au transistor 802. Le transistor 801 a une borne de source reliée, de préférence connectée, à la borne commune de source 252 ;
- un transistor 811, de préférence identique ou similaire au transistor 812. Le transistor 811 a une borne de drain reliée, de préférence connectée, à l'entrée 711 du module 710 et une borne de commande reliée, de préférence connectée, à la borne commune de source 252 ; et
- un élément résistif 821, de préférence de valeur égale à celle de l'élément résistif 822. L'élément résistif 821 relie la borne de grille du transistor 801 à la borne commune de source 252. Il en résulte, en fonctionnement, un courant I711 circulant parallèlement au premier interrupteur 210-1 (figure 7) .

Dans l'exemple représenté, la borne de drain du transistor 801 est reliée à la borne 831 d'application de la tension VCC par l'élément résistif 830. Ainsi, le signal S802 est à l'état haut lorsque les deux transistors 801 et 802 sont bloqués, et à l'état bas lorsque l'un au moins des deux transistors 801 et 802 est à l'état passant. Autrement dit, les transistors 801, 802 et l'élément résistif 830 comparent les deux courants I711 et I712 au seuil de courant, et autorisent au signal de commande SC de prendre un état de mise à l'état passant de l'interrupteur bidirectionnel seulement lorsque les deux courants ont des valeurs inférieures au seuil de courant.

Dans d'autres exemples, la liaison entre la borne de drain du transistor 801 et l'élément résistif 830 peut être remplacée par tout circuit apte à permettre au transistor 801 de fournir un signal représentatif de son état passant/bloqué, et à réaliser une fonction logique ET entre ce signal et le signal S802 fourni par le transistor 802.

En variante, les transistors 801 et 802 et l'élément résistif 830 peuvent être remplacés par n'importe quel circuit apte à comparer chacun des courants I711 et I712 à un seuil de courant et à fournir un signal d'autorisation, pour le signal de commande SC, de prendre un état de mise à l'état passant de l'interrupteur bidirectionnel.

La figure 9 représente, de manière schématique et sous forme de chronogrammes, un mode de réalisation d'un procédé mis en oeuvre par le module de la figure 8. Plus précisément, on a représenté en fonction du temps des allures :
- du signal de commande SQW reçu par le module 710 ;
- d'une tension V210-2 aux bornes du deuxième interrupteur ;
- du courant I712 circulant parallèlement au deuxième interrupteur ; et
- du signal de commande SC appliqué à l'interrupteur bidirectionnel par le circuit 702 (figure 7).
A titre d'exemple, ces allures sont représentées au cours d'une période pendant laquelle le circuit 702 maintient le premier interrupteur 210-2 à l'état passant du fait du signe détecté de la tension V200 aux bornes de l'interrupteur bidirectionnel. Dans l'exemple du procédé de la figure 5, ceci correspond à l'une des périodes 522 de détection du signe négatif de la tension V200.

Le signal SQW présente des cycles répétés. A chacun des cycles, le signal SQW bascule de l'état haut à l'état bas à un instant t0 et de l'état bas à l'état haut à un instant t1. A chacun des instants t0 de passage du signal SQW de l'état bas à l'état haut, le signal SC bascule de l'état haut de mise à l'état passant de l'interrupteur bidirectionnel à l'état bas de mise à l'état bloqué de l'interrupteur bidirectionnel. L'interrupteur bidirectionnel passe de l'état passant à l'état bloqué.

Par exemple, à l'instant t0, la tension V210-1 aux bornes du deuxième interrupteur bascule d'une valeur nulle ou sensiblement nulle à une valeur égale, ou sensiblement égale, à la tension V200 aux bornes de l'interrupteur bidirectionnel. Les détails de ce basculement ne sont pas représentés.

Le courant I712 passe d'une valeur nulle à une valeur non nulle à l'instant t0 à partir duquel ce courant I712 est alimenté par la tension V210-2 aux bornes du deuxième interrupteur. Cette valeur non nulle du courant I712 est fonction de la tension V802 fournie par le transistor JFET 812 et de la valeur de résistance de l'élément résistif 822. Cette valeur non nulle du courant I712 est supérieure au seuil de courant ITH.

A chaque cycle, à l'instant t1 de passage du signal SQW de l'état haut à l'état bas, l'interrupteur bidirectionnel reste à l'état bloqué du fait que la valeur du courant I712 est supérieure au seuil ITH. Cependant, à partir de cet instant, un courant circule dans l'interrupteur bidirectionnel en passant par diverses capacités parasites (non représentées) de l'interrupteur bidirectionnel. Dans l'exemple où l'interrupteur bidirectionnel constitue l'interrupteur IH (figure 1) d'une cellule telle que la cellule 100 de la figure 1, ceci peut être obtenu en faisant basculer l'interrupteur IL de l'état passant à l'état bloqué à l'instant t1. Le courant passant dans l'interrupteur IH est alors constitué d'une partie du courant I (figure 1) fourni/reçu par la cellule de commutation et maintenu par une inductance non représentée.

Le courant passant par l'interrupteur bidirectionnel provoque la décharge des capacités parasites. Il en résulte une diminution de la tension V210-1 aux bornes du deuxième interrupteur. Lorsque la tension V210-1 n'est plus suffisante pour maintenir la valeur du courant I711, celui-ci diminue. A un instant t2, le courant I711 franchit le seuil de courant ITH. A cet instant, la tension aux bornes du deuxième interrupteur est nulle ou sensiblement nulle (par rapport à la tension V200) . Du fait que le premier interrupteur est maintenu à l'état passant au cours des cycles considérés du signal SQW, la tension aux bornes de l'interrupteur bidirectionnel est nulle ou sensiblement nulle à l'instant t2.

Du franchissement du seuil de courant ITH par le courant I712, il résulte que le signal S802 (figure 8) passe au niveau haut, et autorise le signal SC à prendre le niveau haut. Ainsi, le signal SC passe au niveau haut à l'instant t2, ce qui provoque le passage de l'interrupteur bidirectionnel à l'état passant.

On a ainsi mis en oeuvre une commutation de type ZVS de l'interrupteur bidirectionnel pendant les périodes pendant lesquelles le premier interrupteur est maintenu à l'état passant. Les commutations de type ZVS permettent d'améliorer la fiabilité et le rendement du convertisseur.

Selon un avantage, la durée entre les instants t1 et t2 pendant laquelle les deux interrupteurs bidirectionnels IH et IL (figure 1) de la cellule de commutation sont à l'état bloqué (c'est-à-dire le temps mort de commutation), est obtenue de manière simple sans avoir besoin, par exemple, de la prérégler à des valeurs prédéfinies différentes en fonction de la tension aux bornes de la cellule de commutation.

Dans le cas préféré où le module 710 comprend en outre le transistor 801, l'élément résistif 821 et le transistor JFET 811, le fonctionnement du module 710 est, pendant les périodes où le deuxième interrupteur est maintenu à l'état passant (périodes 512 dans l'exemple de la figure 5), similaire à celui décrit ci-dessus pour les périodes où le premier interrupteur est maintenu à l'état passant, à savoir :
- lorsque le premier interrupteur est à l'état bloqué, faire circuler le courant I711 ; et
- passer le premier interrupteur de l'état bloqué à un état passant à un instant ou le courant I711 devient inférieur à un seuil de courant, par exemple le seuil de courant ITH. Les commutations de l'interrupteur bidirectionnel sont alors de type ZVS quel que soit le signe détecté de la tension aux bornes de l'interrupteur bidirectionnel.

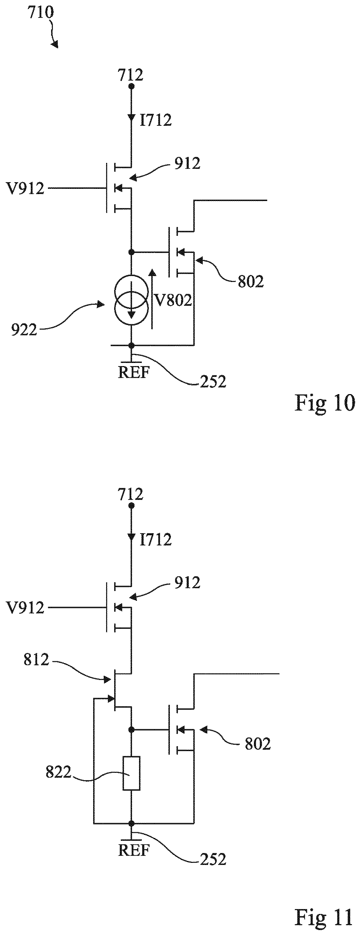

La figure 10 représente, de manière partielle et schématique, un autre mode de réalisation du module 710 du circuit de la figure 7. Ce mode de réalisation diffère de celui de la figure 8 en ce que :
- le transistor JFET 812 (figure 8) est remplacé par un transistor 912 à effet de champ à canal N reliant l'entrée 712 à la borne de commande du transistor 802 et commandé par une tension V912. La tension V912 est référencée par rapport au potentiel REF de la borne commune de source 252 ; et
- de préférence, l'élément résistif 822 (figure 8) est remplacé par une source de courant 922 reliant la borne de commande du transistor 802 à la borne commune de source 252.

Le fonctionnement est le même que celui décrit ci-dessus pour le mode de réalisation de la figure 8. Le transistor 912 maintient la tension de commande V802 à une valeur proche de celle de la tension V912, à une tension de seuil près du transistor 911. La source 922, ou l'élément résistif 822 (figure 8) dans le cas où l'élément résistif 822 n'est pas remplacé par la source 922, consomme un courant.

De manière similaire, le transistor JFET 811 (figure 8) peut être remplacé par un transistor 912 à effet de champ à canal N reliant l'entrée 711 à la borne de commande du transistor 801 et commandé par une tension similaire, par exemple égale, à la tension V912. L'élément résistif 822 (figure 8) peut également être remplacé par une source de courant reliant la borne de commande du transistor 801 (figure 8) à la borne commune de source 252.

La figure 11 représente, de manière partielle et schématique, un autre mode de réalisation d'un module du circuit de la figure 7. Ce mode de réalisation diffère de celui de la figure 8 en ce que le transistor JFET 812 a son drain relié à l'entrée 712 par un transistor 912 identique ou similaire au transistor 912 décrit ci-dessus en relation avec la figure 10, commandé par la tension V912.

Selon un avantage, le transistor 912 permet d'éviter au transistor JFET 812 d'être soumis à la totalité de la tension aux bornes du deuxième interrupteur. Cette tension est majoritairement bloquée par le transistor 912.

De manière similaire, le transistor JFET 811 (figure 8) peut avoir son drain relié à l'entrée 712 (figure 8) par un transistor identique ou similaire au transistor 912, avec le même avantage que ci-dessus.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, des modes de réalisation diffèrent de ceux des figures 8, 10 et 11, en ce que les positions de la source de tension de commande des transistors 801 et/ou 802 sont échangées avec celles des charges consommant les courant respectifs I711 et/ou I712.

En outre, bien que, dans des exemples décrits ci-dessus, des niveaux haut et bas de signaux constituent des niveaux de mise à des états respectifs passant et bloqué d'interrupteur, on peut choisir pour chacun de ces signaux tout premier niveau de mise à un état passant d'interrupteur et tout deuxième niveau de mise à un état bloqué d'interrupteur.

Enfin, la mise en oeuvre pratique des modes de réalisation et variantes décrits est à la portée de la personne du métier à partir des indications fonctionnelles données ci-dessus.

## Revendications

1. Procédé de commande d'un interrupteur bidirectionnel (200), comprenant :
- des premier (210-1) et deuxième (210-2) transistors à effet de champ électriquement en série entre des première (262-1) et deuxième (262-2) bornes de l'interrupteur bidirectionnel ;
- un détecteur (310) d'un signe de la tension (V200) entre la première borne et la deuxième borne (262-1, 262-2), ledit détecteur étant alimenté par une tension référencée au potentiel d'un premier noeud (252) auquel sont connectées les sources communes des premier et deuxième transistors,
comprenant des étapes consistant à :
- recevoir une tension (V200) entre les bornes de l'interrupteur bidirectionnel ;
- détecter, à partir de la tension reçue, un signe de ladite tension ;
- au moins pendant qu'un premier signe est détecté, relier la première borne audit premier noeud (252), des potentiels de bornes de commande des premier et deuxième transistors étant référencés par rapport au potentiel (REF) dudit premier noeud (252) ;
- au moins pendant que le deuxième signe est détecté, connecter la deuxième borne (262 2) audit premier noeud (252) .

2. Procédé selon la revendication 1, dans lequel l'étape consistant à connecter la première borne (262-1) audit noeud de connexion (252) comprend le maintien à un état passant du premier transistor (210-1).

3. Procédé selon la revendication 1 ou 2, comprenant en outre, pendant l'étape consistant à connecter la première borne (262-1) audit noeud de connexion (252), des étapes consistant à :
- mettre le deuxième transistor (210-2) à un état bloqué ;
- lorsque le deuxième transistor est à l'état bloqué, générer un courant (I712) en parallèle du deuxième transistor entre les bornes (262-2, 252) du deuxième transistor, alimenté par une tension (V210-2) entre les bornes du deuxième transistor ; et
- passer le deuxième transistor de l'état bloqué à un état passant à un instant (t2) où le courant en parallèle du deuxième transistor devient inférieur à un seuil de courant (ITH).

4. Procédé selon l'une quelconque des revendications 1 à 3, dans lequel l'étape consistant à connecter la deuxième borne (262-2) audit noeud de connexion (252) comprend le maintien à un état passant du deuxième transistor (210-2).

5. Procédé selon la revendication 4, comprenant en outre, pendant l'étape consistant à connecter la deuxième borne (262-2) audit noeud de connexion (252), des étapes consistant à :
- mettre le premier transistor (210-1) à un état bloqué ;
- lorsque le premier transistor est l'état bloqué, générer un courant (I711) en parallèle du premier transistor, alimenté par une tension entre les bornes (262-1, 252) du premier transistor ; et
- passer le premier transistor de l'état bloqué à un état passant à un instant où le courant en parallèle du premier transistor devient inférieur à un seuil de courant.

6. Procédé selon l'une quelconque des revendications 1 à 5, dans lequel les premier et deuxième transistors sont de même type de canal, de préférence des transistors de type HEMT à GaN.

7. Procédé selon la revendication 6, dans lequel ledit interrupteur bidirectionnel (200) est monolithique et comprend un substrat (232) relié, de préférence par une impédance, à la borne commune de source (252).

8. Procédé selon l'une quelconque des revendications 1 à 7, dans lequel des troisième (614) et quatrième (612) transistors à effet de champ sont électriquement en série entre lesdites première (262 1) et deuxième (262 2) bornes de l'interrupteur bidirectionnel, le premier noeud (252) de connexion en série des premier (210 1) et deuxième (210 2) transistors étant commun à un deuxième noeud (616) de connexion en série des troisième (614) et quatrième (612) transistors.

9. Circuit comprenant :
des premier et deuxième transistors formant un commutateur avec des sources communes et étant électriquement en série entre des première et deuxième bornes (262-1, 262-2) ;
un détecteur (310) d'un signe de la tension (V200) entre la première borne et la deuxième borne (262-1, 262-2), ledit détecteur étant alimenté par une tension référencée au potentiel d'un premier noeud (252) auquel sont connectées les sources communes des premier et deuxième transistors, et une sortie dudit détecteur étant utilisé par des éléments du circuit pour, au moins lorsqu'un premier signe est détecté, coupler la première borne au premier nœud et pour, au moins lorsqu'un deuxième signe est détecté, coupler la deuxième borne audit premier nœud ;
des premier et deuxième circuits d'attaque (334, 332) commandant chacun l'un desdits premier et deuxième transistors à partir d'un signal de commande (SC), des potentiels de bornes de commandes des premier et deuxième transistors étant référencés au potentiel (REF) dudit premier noeud (252) ; lesdits circuit d'attaque étant alimentés par une tension (Vcc) référencée audit potentiel dudit premier noeud.

10. Circuit selon la revendication 9, configuré pour mettre en oeuvre un procédé selon l'une quelconque des revendications 1 à 8.

11. Circuit selon la revendication 9 ou 10, comportant des bornes respectivement reliées à chaque borne (262-1, 262-2) de l'interrupteur bidirectionnel, à la borne commune de source (252) des premier et deuxième transistors et aux bornes de commande des transistors.

12. Circuit selon l'une quelconque des revendications 9 à 11, comportant en outre des première et deuxièmes portes logiques de type OU, une première entrée des deux portes recevant un signal de commande (SC) et une deuxième entrée de chaque porte étant couplée à une sortie dudit détecteur, les sorties des première et deuxième portes OU étant respectivement couplées à une entrée desdits premier et deuxième circuits d'attaque.

13. Circuit selon l'une quelconque des revendications 9 à 12, comprenant :
- un cinquième transistor (802) configuré pour fournir un premier signal (S802) d'autorisation de mise à l'état passant du deuxième transistor (210-2) ;
- une première source (812, 912) d'une tension de commande du cinquième transistor, reliée à une borne de conduction (262-2) du deuxième transistor ; et
- une première charge (822, 922) reliant la borne de commande du cinquième transistor à une autre borne de conduction (252) du deuxième transistor.

14. Circuit selon la revendication 13, comprenant en outre :
- un sixième transistor (801) configuré pour fournir un deuxième signal d'autorisation de mise à l'état passant du premier transistor (210-1) ;
- une deuxième source (811) d'une tension de commande du sixième transistor, reliée à une borne de conduction (262-1) du premier transistor ; et
- une deuxième charge (821) reliant la borne de commande du sixième transistor à une autre borne de conduction (252) du sixième transistor.

15. Dispositif (300, 600, 700) comprenant un circuit selon l'une quelconque des revendications 9 à 14 et ledit interrupteur bidirectionnel (200).

16. Dispositif monolithique comprenant un circuit selon l'une quelconque des revendications 9 à 14 ou un dispositif selon la revendication 15.

17. Convertisseur à découpage comprenant un ou plusieurs dispositifs selon la revendication 15 ou 16.

18. Convertisseur selon la revendication 17, configuré pour recevoir et/ou fournir une tension alternative (VAC), comprenant deux interrupteurs bidirectionnels (IH, IL) formés chacun des premier et deuxième transistors (210-1, 210-2) de l'un desdits dispositifs, les deux interrupteurs bidirectionnels étant électriquement en série entre deux noeuds (102, 104) d'application de la tension alternative.

## Patentansprüche

1. Verfahren zum Steuern eines bidirektionalen Schalters (200), aufweisend:
- erste (210-1) und zweite (210-2) Feldeffekttransistoren elektrisch in Reihe zwischen ersten (262-1) und zweiten (262-2) Anschlüssen des bidirektionalen Schalters;
- einen Sensor (310) für das Vorzeichen der Spannung (V200) zwischen dem ersten Anschluss und dem zweiten Anschluss (262-1, 262-2), wobei der Sensor mit einer Spannung versorgt wird, die auf das Potenzial eines ersten Knotens (252) referenziert ist, an den die gemeinsamen Sources der ersten und des zweiten Transistoren angeschlossen sind,
wobei das Verfahren die folgenden Schritten aufweist:
- Empfangen einer Spannung (V200) zwischen den Anschlüssen des bidirektionalen Schalters;
- Detektieren des Vorzeichens der Spannung anhand der empfangenen Spannung;
- wenigstens während des Detektierens eines ersten Vorzeichens, Verbinden des ersten Anschlusses mit dem ersten Knoten (252), wobei die Potentiale der Steueranschlüsse des ersten und zweiten Transistors bezüglich des Potentials (REF) des ersten Knotens (252) referenziert sind;
- wenigstens während des Detektierens des zweiten Vorzeichens, Verbinden des zweiten Anschlusses (262 2) mit dem ersten Knoten (252).

2. Verfahren nach Anspruch 1, wobei der Schritt des Verbindens des ersten Anschlusses (262-1) mit dem Verbindungsknoten (252) das Halten des ersten Transistors (210-1) im Durchlasszustand aufweist.

3. Verfahren nach Anspruch 1 oder 2, das ferner während des Schritts des Verbindens des ersten Anschlusses (262-1) mit dem Verbindungsknoten (252) die folgenden Schritte aufweist:
- Setzen des zweiten Transistors (210-2) in einen Blockierzustand;
- wenn der zweite Transistor in einen Blockierzustand ist, Erzeugen eines Stroms (I712) parallel zum zweiten Transistor zwischen den Anschlüssen (262-2, 252) des zweiten Transistors, der über eine Spannung (V210-2) zwischen den Anschlüssen des zweiten Transistors angetrieben wird; und
- Überführen des zweiten Transistors aus dem Blockierzustand in einen Durchlasszustand zu einem Zeitpunkt (t2), zu dem der Strom parallel zum zweiten Transistors unter einen Stromschwellenwert (ITH) fällt.

4. Verfahren nach einem der Ansprüche 1 bis 3, wobei der Schritt des Verbindens des zweiten Anschlusses (262-2) mit dem Verbindungsknoten (252) das Halten des zweiten Transistors (210-2) in einem Durchlasszustand aufweist.

5. Verfahren nach Anspruch 4, ferner aufweisend, während des Schritts des Verbindens des zweiten Anschlusses (262-2) mit dem Verbindungsknoten (252), die folgenden Schritte:
- Setzen des ersten Transistors (210-1) in einen Blockierzustand;
- wenn der erste Transistor in einen Blockierzustand ist, Erzeugen eines Stroms (I711) parallel zum ersten Transistor, der über einer Spannung zwischen den Anschlüssen (262-1, 252) des ersten Transistors angetrieben wird; und
- Überführen des ersten Transistors vom Blockierzustand in einen Durchlasszustand zu einem Zeitpunkt, zu dem der Strom parallel zum ersten Transistor kleiner als ein Stromschwellenwert wird.

6. Verfahren nach einem der Ansprüche 1 bis 5, wobei der erste und der zweite Transistor vom gleichen Kanaltyp sind, vorzugsweise Transistoren GaN HEMT Typs.

7. Verfahren nach Anspruch 6, wobei der bidirektionale Schalter (200) monolithisch ist und ein Substrat (232) aufweist, das vorzugsweise über eine Impedanz mit dem Source Gemeinschaftsanschluss (252) verbunden ist.

8. Verfahren nach einem der Ansprüche 1 bis 7, wobei dritte (614) und vierte (612) Feldeffekttransistoren elektrisch in Reihe zwischen dem ersten (262 1) und dem zweiten (262 2) Anschluss des bidirektionalen Schalters geschaltet sind, wobei der erste Knoten (252) für die Reihenschaltung der ersten (210 1) und zweiten (210 2) Transistoren einem zweiten Knoten (616) für die Reihenschaltung der dritten (614) und vierten (612) Transistoren gemein ist.

9. Schaltung aufweisend:
erste und zweite Transistoren, die einen Schalter bilden, deren Sources gemein sind, und die elektrisch in Reihe zwischen ersten und zweiten Anschlüssen (262-1, 262-2) geschaltet sind;
einen Sensor (310) für ein Vorzeichens der Spannung (V200) zwischen dem ersten Anschluss und dem zweiten Anschluss (262-1, 262-2), wobei der Sensor mit einer Spannung betrieben wird, die auf das Potential eines ersten Knotens (252) referenziert ist, mit dem die gemeinsamen Sources der ersten und zweiten Transistoren verbunden sind, und wobei ein Ausgang des Sensors von Elementen der Schaltung verwendet wird zum, zumindest wenn ein erstes Vorzeichen detektiert wird, Koppeln den ersten Anschluss mit dem ersten Knoten, und zum, zumindest wenn ein zweites Vorzeichen detektiert wird, Koppeln des zweiten Anschluss mit dem ersten Knoten;
erste und zweite Treiberschaltungen (334, 332), die jeweils einen der ersten und zweiten Transistoren über ein Steuersignal (SC) steuern, wobei die Potentiale des Steueranschlusses der ersten und zweiten Transistoren bezüglich eines Potentials (REF) des ersten Knotens (252) referenziert sind; wobei die Treiberschaltungen mit einer Spannung (Vcc) betrieben werden, die auf das Potential des ersten Knotens referenziert ist.

10. Schaltung nach Anspruch 9, die konfiguriert ist zum Durchführen eines Verfahrens nach einem der Ansprüche 1 bis 8.

11. Schaltung nach Anspruch 9 oder 10, aufweisend Anschlüsse, die jeweils verbunden sind mit jedem Anschluss (262-1, 262-2) des bidirektionalen Schalters, mit dem gemeinsamen Source-Anschluss (252) der ersten und zweiten Transistoren und mit den Steueranschlüssen der Transistoren.

12. Schaltung nach einem der Ansprüche 9 bis 11, ferner aufweisend erste und zweite logische ODER-Gatter, wobei ein erster Eingang der beiden Gatter ein Steuersignal (SC) empfängt und ein zweiter Eingang jedes Gatters mit einem Ausgang des Sensors verbunden ist, wobei die Ausgänge der ersten und zweiten ODER-Gatter jeweils mit einem Eingang der ersten und zweiten Treiberschaltungen verbunden sind.

13. Schaltung nach einem der Ansprüche 9 bis 12, aufweisend:
- einen fünften Transistor (802), der konfiguriert ist zum Vorsehen eines ersten Signals (S802), das das Setzen des zweiten Transistors (210-2) in den Durchlasszustand erlaubt;
- eine erste Source (812, 912) einer Steuerspannung des fünften Transistors, die mit einem Leitungsanschluss (262-2) des zweiten Transistors verbunden ist; und
- eine erste Last (822, 922), die den Steueranschluss des fünften Transistors mit einem anderen Leitungsanschluss (252) des zweiten Transistors verbindet.

14. Schaltung nach Anspruch 13, ferner aufweisend:
- einen sechsten Transistor (801), der konfiguriert ist zum Vorsehen eines zweiten Signals, das das Setzen des ersten Transistors (210-1) in einen Durchlasszustand erlaubt;
- eine zweite Source (811) einer Steuerspannung des sechsten Transistors, die mit einem Leitungsanschluss (262-1) des ersten Transistors verbunden ist; und
- eine zweite Last (821), die den Steueranschluss des sechsten Transistors mit einem anderen Leitungsanschluss (252) des sechsten Transistors verbindet.

15. Vorrichtung (300, 600, 700) aufweisend eine Schaltung nach einem der Ansprüche 9 bis 14 und den bidirektionalen Schalter (200).

16. Monolithische Vorrichtung aufweisend eine Schaltung nach einem der Ansprüche 9 bis 14 oder eine Vorrichtung nach Anspruch 15.

17. Schaltwandler aufweisend eine oder mehrere Vorrichtungen nach Anspruch 15 oder 16.

18. Wandler nach Anspruch 17, der konfiguriert ist zum Empfangen und/oder Liefern einer Wechselspannung (VAC), aufweisend zwei bidirektionale Schaltern (IH, IL), die jeweils aus ersten und zweiten Transistoren (210-1, 210-2) gebildet sind, wobei bei einer der Vorrichtungen die beiden bidirektionalen Schalter elektrisch in Reihe zwischen zwei Knoten (102, 104) zum Anlegen der Wechselspannung geschaltet sind.

## Claims

1. Method of controlling a bidirectional switch (200), comprising:
- first (210-1) and second (210-2) field effect transistors electrically in series between first (262-1) and second (262-2) terminals of the bidirectional switch;
- a sensor (310) of a sign of the voltage (V200) between the first terminal and the second terminal (262-1, 262-2), said sensor being powered with a voltage referenced with respect to the potential of a first node (252) to which the common sources of the first and second transistors are connected,
comprising steps of:
- receiving a voltage (V200) between the terminals of the bidirectional switch;
- detecting, from the voltage received, a sign of said voltage;
- at least while a first sign is detected, connecting the first terminal to said first node (252), potentials of control terminals of the first and second transistors being referenced with respect to the potential (REF) of said first node (252);
- at least while the second sign is detected, connecting the second terminal (262 2) to said first node (252).

2. Method according to claim 1, wherein the step of connecting the first terminal (262-1) to said connection node (252) comprises holding the first transistor (210-1) on.

3. Method according to claim 1 or 2, further comprising, during the step of connecting the first terminal (262-1) to said connection node (252), the steps of:
- setting the second transistor (210-2) to an off state;
- when the second transistor is in the off state, generating a current (1712) in parallel with the second transistor between the terminals (262-2, 252) of the second transistor, powered with a voltage (V210-2) between the terminals of the second transistor; and
- triggering the second transistor from the off state to an on state at a time (t2) when the current in parallel of the second transistor becomes lower than a current threshold (ITH).

4. Method according to any one of claims 1 to 3, wherein the step of connecting the second terminal (262-2) to said connection node (252) comprises holding the second transistor (210-2) in an on state.

5. Method according to claim 4, further comprising, during the step of connecting the second terminal (262-2) to said connection node (252), the steps of:
- setting the first transistor (210-1) to an off state;
- when the first transistor is in the off state, generating a current (I711) in parallel with the first transistor, powered with a voltage between the terminals (262-1, 252) of the first transistor; and
- triggering the first transistor from the off state to an on state at a time when the current in parallel with the first transistor becomes less than a current threshold.

6. Method according to any one of claims 1 to 5, wherein the first and second transistors are of the same channel type, preferably GaN HEMT type transistors.

7. Method according to claim 6, wherein said bidirectional switch (200) is monolithic and comprises a substrate (232) connected, preferably by an impedance, with the source common terminal (252).

8. Method according to any one of claims 1 to 7, wherein third (614) and fourth (612) field-effect transistors electrically in series between said first (262 1) and second (262 2) terminals of the bidirectional switch, the first node (252) for series connection of the first (210 1) and second (210 2) transistors being common to a second node (616) for series connection of the third (614) and fourth (612) transistors.

9. Circuit comprising:
first and second transistors forming a switch having common sources and being electrically in series between first and second terminals (262-1, 262-2);
a sensor (310) of a sign of the voltage (V200) between the first terminal and the second terminal (262-1, 262-2), said sensor being powered with a voltage referenced with respect to the potential of a first node (252) to which the common sources of the first and second transistors are connected, and an output of said sensor being used by elements of the circuit in order to, at least when a first sign is detected, coupling the first terminal to the first node, and to, at least when a second sign is detected, coupling the second terminal to said first node;
first and second driving circuits (334, 332) each controlling one of said first and second transistors from a control signal (SC), the potentials of the control terminal of the first and second transistors being referenced with respect to a potential (REF) of said first node (252); said driving circuits being powered with a voltage (Vcc) referenced with respect to said potential of said first node.

10. Circuit according to claim 9, configured to implement a method according to any one of claims 1 to 8.

11. Circuit according to claim 9 or 10, including terminals connected to each terminal (262-1, 262-2) of the bidirectional switch, to the common source terminal (252) of the first and second transistors, and to the control terminals of the transistors, respectively.

12. Circuit according to any one of claims 9 to 11, further including first and second OR-type logic gates, a first input of the two gates receiving a control signal (SC) and a second input of each gate being coupled to an output of said sensor, the outputs of the first and second OR gates being coupled to an input of said first and second driving circuits, respectively.

13. Circuit according to any one of claims 9 to 12, comprising:
- a fifth transistor (802) configured to provide a first signal (S802) enabling the second transistor (210-2) to be turned on;
- a first source (812, 912) of a control voltage of the fifth transistor, connected to a conduction terminal (262-2) of the second transistor; and
- a first load (822, 922) connecting the control terminal of the fifth transistor to another conduction terminal (252) of the second transistor.

14. Circuit according to claim 13, further comprising:
- a sixth transistor (801) configured to provide a second enabling signal for turning the first transistor (210-1) on;
- a second source (811) of a control voltage of the sixth transistor, connected to a conduction terminal (262-1) of the first transistor; and
- a second load (821) connecting the control terminal of the sixth transistor to another conduction terminal (252) of the sixth transistor.

15. Device (300, 600, 700) comprising a circuit according to any one of claims 9 to 14 and said bidirectional switch (200).

16. Monolithic device comprising a circuit according to any one of claims 9 to 14 or a device according to claim 15.

17. Switching converter comprising one or more devices according to claim 15 or 16.

18. Converter according to claim 17, configured to receive and/or supply an AC voltage (VAC), comprising two bidirectional switches (IH, IL) each formed of first and second transistors (210-1, 210-2) of one of said devices, the two bidirectional switches being electrically in series between two nodes (102, 104) for applying the AC voltage.
